(19)

Europäisches
Patentamt
European
Patent Office
Office européen
des brevets

(11)     **EP 2 056 115 A1**

(12)     **EUROPEAN PATENT APPLICATION**

(43) Date of publication:
    **06.05.2009   Bulletin 2009/19**

(51) Int Cl.:
    ***G01R 15/09*** *(2006.01)*

(21) Application number: **07119937.6**

(22) Date of filing: **03.11.2007**

(84) Designated Contracting States:
    **AT BE BG CH CY CZ DE DK EE ES FI FR GB GR
    HU IE IS IT LI LT LU LV MC MT NL PL PT RO SE
    SI SK TR**
    Designated Extension States:
    **AL BA HR MK RS**

(71) Applicant: **Quaere Novum Enterprises
    26121 Oldenburg (DE)**

(72) Inventors:
    • **Boers, Dave
      Quaere Novum Enterprises
      26121 Oldenburg (DE)**
    • **Neun, Guido
      Quaere Novum Enterprises
      26121 Oldenburg (DE)**
    • **Ritz, Axel
      Quaere Novum Enterprises
      26121 Oldenburg (DE)**

(54)    **Autoranging Power Measurements for Smart Metering in Households, Small Business and
        Appliances**

(57)    This application concerns a device for autoranging highly accurate power measurements, specifically of electrical current, using current transducers such as Rogowski coils, incorporating a Time Division Multiplexing Subrange selection mechanism, analog to digital modulators, and a state machine for cycling through the various measurement subranges in order to automatically select the optimal range, effectively widening the dynamic range of the employed analog to digital modulators. Envisioned Applications include, but are not limited to, smart metering in households, small business and appliances, "zooming in" on very small standby currents, and wide range measurement applications in distribution automation.

FIG. 1: Example embodiment of the invention

**Description**

The invention generally relates to digital signal processing, energy measurement, and digital metering using current transducers. More particularly, the invention relates to the Time Division Multiplexing over different sensor subranges in order to implement an autoscaling energy measurement device for alternating current flows.

**A. Relevant prior art with citations**

Measurement devices for electrical power measurements require a current transducer. Among others, shunts, current transformers, rogowski coils, or Hall sensors can be used as the current transducer.

In the particular case of using an air-cored rogowski coil as the current transducer, the transducer will have a very wide dynamic range in which it behaves linearly.

Commonly, analog-to-digital converters (ADC), such as sigma delta modulators, are used to provide a digital signal representative of the analog signal from the current transducer (rogowski coil), which is then passed for further processing, interpreting and possibly storage or communication to a. finite or infinite state machine (for the sake of clarity, we call this processing unit the DSPU, digital signal processing unit). Reference is made to U.S. Pat. No. 6,040,793, ($\Sigma\Delta$-ADC), the contents of which are incorporated herein by reference.

An ADC can be adapted to time division multiplexing (TDM) between multiple input signals. Such a multiplexing ADC is described for example, in "A Programmable Power Metering Chip," Y.M. Lin et. al., Proceedings of the IEEE 1993 Custom Integrated Circuits Conference, 1993, pp. 25.7.1-25.7.4, incorporated herein by reference. Further description of such an approach is also provided in "A Single Shot Sigma Delta Analog to Digital Converter for Multiplexed Applications"; C. Lyden, et al, and US Pat. Nos. 5,544,089; 5,345,236; and 5,627,536, all of which are incorporated herein by reference.

An application incorporating multiplexing and ADC for power measurement devices over three different phase lines is described in US Pat. No. 6,593,865, which is incorporated herein by reference.

When a sigma delta modulator is used for a TDM ADC, further filtering and decimation is generally required after the output bit stream has been de-multiplexed into multiple TDM bit streams. And when switching from one input signal to the next, the internal analog integrators and the output digital filter all have to settle to appropriate conditions for the new input signal waveform. Typically this settling time is longest for the digital filter.

**II. TECHNICAL PROBLEM TO BE SOLVED**

One specific application for a multiplexed ADC would be in an electrical power measuring device. In contemporary power distribution systems, the fundamental line frequency is typically 50 or 60 Herz, but it should be appreciated that significant energy is present in harmonics as high as the 15th harmonic. The dynamic range requirements of an ADC are also formidable: 20 bits of digital resolution are needed to achieve an accuracy within 0.1% over a 1000:1 current range. On the other hand, typical air-cored rogowski coil current transducers can be linear over a 1000000:1 current range.

The technical problem to be solved is to subdivide the dynamic range of the current transducer into subranges, or to use several current transducers with different ranges, and selecting the ranges through a multiplexer. The multiplexer is triggered by a TDM clock signal and the resulting digital measurement signal is processed and demultiplexed by the DSPU. Either a separate multiplexer can be used, or a multiplexing ADC is used in the first place.

The technical problem to be solved consists of programming the DSPU so that for each full TDMA cycle, the optimal signal subrange is selected automatically.

Applications include but are not limited to: autoranging for smart metering in households, small businesses and appliances to "zoom in" on small standby currents, failure currents, device characteristic noise in appliance power consumption, or for detecting very large failure currents which typically cause a circuit breaker to open, assisting in tracing the appliance causing the circuit breaker to open.

**III. DISCLOSURE OF THE INVENTION**

The distinction between rogowski coils and current transformers is not trivial. In particularly they seem, on first sight, to be topologically equivalent. There are metal-cored rogowski coils as well as air-cored current transformers, although typical current transformers are metal-cored, and typical rogowski coils are air-cored. Both belong to the ontological class of current transducers.

The distinction between current transformers and Rogowski coils consists of the load on the secondary winding side. Current transformers have a comparatively low impedance load resistor chosen specifically so that the voltage over this transistor is proportional to the primary current to be measured in a desired dynamic range. Rogowski coils, on the other hand, are operated nearly open-loop on the secondary side. Their induced voltage is proportional to the first time derivative of the primary current.

Due to the metal core in current transformers, these have only a limited useful range in which they transduce linearly. Air-cored Rogowski coils (di/dt sensors) do not suffer from this deficiency. They usually behave linearly over a huge dynamic range.

In typical metering/measuring applications, an ADC is used in combination with a Rogowski coil di/dt sensor to obtain a digital representation of the secondarily induced voltage. An ADC usually has an imput impedance in the range of 1 Mega-Ohm. Let us assume, the ADC has exactly 1 Mega-Ohm imput impedance. We now construct a tenfold resistor cascade in parallel to the ADC input, where each of the resistors in the cascade has a resistance of 10 Mega-Ohms, the total cascade thus consisting of an effective 100 Mega-Ohm resistor. This effectively changes the imput impedance of the combined cascade and ADC circuit to

$$\frac{1}{R} = \frac{1}{100} + \frac{1}{1} \approx 0.99 \text{ Mega-Ohms} \tag{1}$$

which does not significantly change the behaviour of the rogowsky coil transducer. This consideration can readily be generalised to a cascade of *N* high-impedance resistors, not necessarily all of the same resistive value. One can think of linear cascades, logarithmic cascades, combinations of both or nonlinear cascades for special purposes.

The idea is to use the resistor cascade as a voltage dividor for the di/dt signal of the rogowsky coil. Selecting different taps on the voltage dividor resistor cascade effectively selects a subrange of the di/dt signal from the Rogowski coil. This subrange is selected by a multiplexer, and offered to the ADC instead of the whole di/dt signal from the Rogowski coil.

If the multiplexer is driven by a time division multiplex (TDM) way, i.e. each clock tick selecting the next tap of the voltage divider circuit, and repeating, while monitoring the overload situation on the ADC either digitally or analog, either using an overload protected ADC or by employing further circuitry to detect the overload situation and protect the ADC, the signal processing digital logic behind the ADC will be able to automatically select the time slot with the optimal dynamic input range for the ADC, thus effectively widening the dynamic range of the ADC automatically.

## A. Example 1

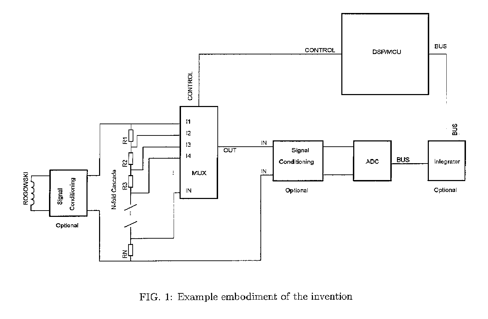

In Figure 1, a possible realisation of the invention is depicted. The coil symbol represents a Rogowski Coil with optional signal condition circuitry. The di/dt signal from the Rogowski Coil is divided in a resistor cascade, each resistor having a very high impedance (each larger than the imput impedance of the ADC). Different taps on the voltage dividing resistor cascade are selected by the multiplexer (MUX), where a DSP/MCU (Digital Signal Processor/Micro Controller Unit) selects the multiplexer input. The output of the MUX corrsponds to a subrange of the voltage of the di/dt Rogowski coil sensor and is fed (possibly through further optional signal processing) to the ADC. The ADC is supposed to be overload-protected in this example. The ADC generates a digital bus signal, which digitally represents the analog input voltage of the ADC. In this example, the digital bus signal may be an SPI bus signal, for example. It is assumed that the digital signal is capable of indicating overload on the ADC inputs. This digital signal is either separately integrated to obtain a digital signal representing the primary current through the Rogowski coil in the optional integrator, or integrated in the DSP/MCU unit. The DSP/MCU unit may have additional inputs for digitized voltage signals to be able to complete necessary calculations for complete power measurement, possibly including real power, VARS, frequency, harmonics, and so on. In a different embodiment of the present invention, the current measurement circuitry may be augmented by a similar circuitry omitting the current transducer in order to measure the voltage accompanying the current. In this case, the voltage lines would be connected directly to the resistor cascade.

The DSP/MCU comprises a finite or an infinitely repeating state machine that cycles the MUX through the separate taps on the resistor cascade, while monitoring the overload condition on the ADC. By selecting the optimal tap corresponding to the optimal input range of the ADC, the autoranging mechanism is implemented.

Other embodiments of the invention may include Microprocessors, analog circuitry, FPGA's, PLD's, or other digital circuitry instead of the depicted DSP or MCU. Furthermore, different embodiments of the invention may employ multiplexing ADC's instead of a separate multiplexing unit, and may employ more or less sophisticated separate overload protection or out-of-range indication mechanisms on the ADC.

Although various exemplary embodiments of the invention have been disclosed, it should be apparent to those skilled in the art that various changes and modifications can be made which will achieve some of the advantages of the invention without departing from the true scope of the invention.

# EP 2 056 115 A1

**Claims**

1. A measurement device comprising:

   (a) at least one current transducer for measuring electrical current
   (b) voltage division circuitry for selecting a plurality of subranges of the transducer output voltage
   (c) a signal control circuit for selecting different subranges of the transducer output voltage
   (d) at least one modulator for processing a selected input signal to produce a representative digital output
   (e) at least one signal control circuit for selecting a signal for a processing period as the selected input signal for a specific modulator
   (f) at least one signal processor to convert the digital output of a modulator into a digital signal representative of the electrical current through the transducer
   (g) possibly one or more signal control circuits implementing a finite or infinitely repeating state machine for combining the digital signal representing the current with auxiliary signals in order to obtain digital signals representative of derived physical quantities.

2. A measurement device according to claim 1, wherein the transducer input signal is either an analog signal, a digital signal, or a digital analog mixed signal.

3. a measurement device according to claim 1, wherein the modulators are sigma delta modulators.

4. a measurement device according to claim 1, wherein the modulators are multiplexing sigma delta modulators.

5. A measurement device according to claim 1, wherein the current transducer is a rogowski coil.

6. A measurement device according to claim 1, wherein the current transducer is a current transformer.

7. A measurement device according to claim 1, wherein the current transducer is a Hall effect sensor.

8. A measurement device according to claim 1, wherein the current transducer is omitted and the resistor cascade is used for a multirange voltage measurement.

9. A measurement device according to claim 1, wherein the signal control circuit for selecting different subranges of the transducer output voltage is a voltage dividing resistor cascade.

10. A measurement device according to claim 1, containing an overload detection mechanism on the modulator(s)

11. A measurement device according to claim 1, wherein the signal selection mechanism is performed by time division multiplexing

FIG. 1: Example embodiment of the invention

**European Patent Office**

**EUROPEAN SEARCH REPORT**

Application Number

EP 07 11 9937

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 724 161 A (EATON CORP [US]) 31 July 1996 (1996-07-31) * figures 1-3 * * column 1, line 5 - line 44 * * column 2, line 13 - line 32 * * column 3, line 5 - column 5, line 38 * ----- | 1-11 | INV. G01R15/09 |
| X | DE 35 41 274 A1 (BBC BROWN BOVERI & CIE [DE]) 27 May 1987 (1987-05-27) * figure 1 * * column 1, line 46 - line 50 * * column 2, line 59 - column 3, line 40 * * column 4, line 1 - line 51 * ----- | 1-11 | |
| X | WO 2007/000062 A (ABB RESEARCH LTD [CH]; DECK BERNHARD [DE]; SABBATTINI BRUNO [CH]; BLOC) 4 January 2007 (2007-01-04) * figure 2 * * page 1, line 5 - page 3, line 28 * * page 4, line 27 - page 5, line 8 * * page 8, line 6 - line 26 * * page 10, line 24 - page 11, line 21 * * page 13, line 16 - line 17 * ----- | 1-11 | |
| X | DE 20 42 687 A1 (SEYFRIED P; FRIEDL R) 2 March 1972 (1972-03-02) * figure 1 * * page 1 - page 3 * ----- | 1-11 | TECHNICAL FIELDS SEARCHED (IPC) G01R |
| A | US 4 723 220 A (SMITH-VANIZ WILLIAM R [US]) 2 February 1988 (1988-02-02) * figure 30 * * column 15, line 57 - line 60 * ----- -/-- | 1-11 | |

The present search report has been drawn up for all claims

| Place of search | Date of completion of the search | Examiner |
|---|---|---|
| Berlin | 19 June 2008 | Höller, Helmut |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P04C01)

**European Patent Office**

## EUROPEAN SEARCH REPORT

Application Number

EP 07 11 9937

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE 100 04 833 A1 (SIEMENS AG [DE]) 2 August 2001 (2001-08-02) * column 2, line 21 - line 54 * * column 4, line 63 - column 5, line 6 * * claims 4,5 * ----- | 1-11 | |
| A | US 4 438 396 A (HARNDEN JR JOHN D [US] ET AL) 20 March 1984 (1984-03-20) * figure 2 * * column 3, line 55 - column 4, line 16 * ----- | 1-11 | |
| | | | TECHNICAL FIELDS SEARCHED (IPC) |

The present search report has been drawn up for all claims

| Place of search | Date of completion of the search | Examiner |
|---|---|---|
| Berlin | 19 June 2008 | Höller, Helmut |

EPO FORM 1503 03.82 (P04C01)

## ANNEX TO THE EUROPEAN SEARCH REPORT
## ON EUROPEAN PATENT APPLICATION NO.

EP 07 11 9937

This annex lists the patent family members relating to the patent documents cited in the above-mentioned European search report.
The members are as contained in the European Patent Office EDP file on
The European Patent Office is in no way liable for these particulars which are merely given for the purpose of information.

19-06-2008

| Patent document cited in search report | | Publication date | Patent family member(s) | | Publication date |
|---|---|---|---|---|---|
| EP 0724161 | A | 31-07-1996 | AU | 695365 B2 | 13-08-1998 |
| | | | AU | 4207596 A | 08-08-1996 |
| | | | BR | 9600507 A | 30-12-1997 |
| | | | CA | 2168159 A1 | 28-07-1996 |
| | | | IN | 186167 A1 | 30-06-2001 |
| | | | JP | 8334532 A | 17-12-1996 |
| | | | NZ | 280855 A | 26-06-1998 |
| | | | US | 5606249 A | 25-02-1997 |
| | | | ZA | 9600557 A | 14-08-1996 |
| DE 3541274 | A1 | 27-05-1987 | NONE | | |
| WO 2007000062 | A | 04-01-2007 | EP | 1896859 A1 | 12-03-2008 |
| DE 2042687 | A1 | 02-03-1972 | NONE | | |
| US 4723220 | A | 02-02-1988 | NONE | | |
| DE 10004833 | A1 | 02-08-2001 | CN | 1395755 A | 05-02-2003 |
| | | | WO | 0157979 A1 | 09-08-2001 |
| | | | EP | 1252693 A1 | 30-10-2002 |
| | | | HK | 1050431 A1 | 18-11-2005 |
| | | | JP | 2003522390 T | 22-07-2003 |
| | | | US | 2003001702 A1 | 02-01-2003 |
| US 4438396 | A | 20-03-1984 | NONE | | |

EPO FORM P0459

For more details about this annex : see Official Journal of the European Patent Office, No. 12/82

**EP 2 056 115 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6040793 A
- US 5544089 A, C. Lyden
- US 5345236 A
- US 5627536 A
- US 6593865 B

### Non-patent literature cited in the description

- **Y.M. LIN.** A Programmable Power Metering Chip. *Proceedings of the IEEE 1993 Custom Integrated Circuits Conference,* 1993, 25.7.1-25.7.4